# EUROPEAN PATENT SPECIFICATION

(11) **EP 1 844 178 B1**
(45) Date of publication and mention of the grant of the patent: **09.03.2016**
(21) Application number: 05857616.6
(22) Date of filing: 30.12.2005
(51) Int. Cl.: C23C 16/00, C23C 16/448, C23C 16/455, C23C 16/52

(54) **HIGH ACCURACY VAPOR GENERATION AND DELIVERY FOR THIN FILM DEPOSITION**
HOCHGENAUE DAMPFERZEUGUNG UND ZUFUHR FÜR DIE DÜNNSCHICHTABSCHEIDUNG
GENERATION ET DISTRIBUTION DE VAPEUR HAUTE PRECISION POUR DEPOT DE COUCHE MINCE

(30) Priority: 30.12.2004 US 640746 P
(43) Date of publication of application: 17.10.2007
(73) Proprietor: MSP CORPORATION, Shoreview, MN 55126 (US)
(72) Inventor: LIU, Benjamin, Y.H., North Oaks, Minnesota 55127 (US); MA, Yamin, Roseville, Minnesota 55113 (US)
(74) Representative: Vidon Brevets & Stratégie
(86) International application number: PCT/US2005/047613
(87) International publication number: WO 2006/098792

(56) References cited:
- US-A- 5 203 925
- US-A- 5 835 677
- US-A- 5 966 499
- US-A- 5 966 499
- US-A1- 2002 164 420
- US-A1- 2002 192 375
- US-A1- 2003 209 201
- US-A1- 2003 209 201
- US-B1- 6 178 925
- US-B1- 6 178 925
- US-B1- 6 409 839
- US-B1- 6 409 839

## Description

### FIELD OF THE INVENTION

This invention relates to an apparatus for thin film deposition for semiconductor device fabrication and related applications. Specifically, it involves thin film deposition with liquid precursor chemicals that must be vaporized prior to film deposition. The apparatus described involves direct liquid injection into a heated chamber to generate vapor for delivery to the deposition chamber for film formation. The apparatus is particularly useful for those applications where the rate of vapor delivery is small and for which the method that is presently in use is unsatisfactory.

### BACKGROUND OF THE INVENTION

Thin film formation by chemical vapor deposition (CVD) is a well known process for fabricating semiconductor devices. In the conventional CVD, a precursor vapor is introduced into a chamber in which one or more semiconductor wafers are held at a suitable temperature and pressure to form a thin film on the wafer surface. Insulating, conducting and semi-conducting thin films can be formed by the CVD process by choosing a suitable precursor chemical and the operating conditions of the chamber. When the precursor is a liquid at room temperature, the liquid must be vaporized to form a vapor for film deposition. The process is often referred to as metal organic CVD, or MOCVD, since the precursor used is often made of a metal organic compound. Apparatus for liquid precursor vaporization plays an important role in CVD or MOCVD applications. It must be designed properly and be capable of operating with repeatability for accurate vapor delivery to achieve uniform, high quality thin films that are needed for high volume commercial production of semiconductor, integrated circuit devices.

When the desired film thickness is sufficiently small and approaches 50 Angstrom (A) or so in thickness, the Atomic Layer Deposition (ALD) process becomes increasingly preferred over the conventional CVD process. In ALD, two complementary vapor pairs are used. One, such as ammonia, is first chemisorbed onto the wafer surface to form a monolayer of the first vapor. A second vapor is then introduced, which reacts with the first chemisorbed vapor layer on the wafer to form a single monolayer of the desired film. The process is repeated as many times as necessary in order to form multiple atomic layers of films with the desired overall thickness. The ALD process produces film with good step coverage and excellent conformity to the topography and underlying surface structure on the wafer. The film thickness can also be precisely controlled. For these reasons, ALD processes are finding increased use in semiconductor device fabrication when advanced integrated circuit chips with small geometrical dimensions and film thickness are needed.

For ALD with a liquid precursor, a commonly used vaporization method is to heat the liquid in a vessel to generate vapor at a sufficiently high vapor pressure. The vapor is then introduced into the deposition chamber by opening appropriate valves. Such a prior art system is described in Dennis M. Hausmann, Esther Kim, Jill Becker, and Roy G. Gordon "Atomic Layer Deposition of Hafnium and Zirconium Oxides Using Metal Amide Precursors" Chem. Mater. 14: 4350-4358, 2002. Various dielectric thin films such as metal oxides and nitrides including SiO₂, HfO₂, ZrO₂, WO₃, and WN have been produced by this method using ALD. Jill S. Becker and Roy G. Gordon "Diffusion barrier properties of tungsten nitride films grown by atomic layer deposition from bis(tert-butylimido)bis(dimethylamido)tungsten and ammonia" Applied Physics Letters: 82 (14) April 7, 2003, Dennis M. Hausmann, Roy G. Gordon "Surface morphology and crystallinity control in the atomic layer deposition (ALD) of hafnium and zirconium oxide thin films", Journal of Crystal Growth 249: 251-261, 2003.

Another method for vapor generation is by means of a bubbler. In the bubbler method, the liquid is placed in a heated vessel and a carrier gas is bubbled through the liquid to saturate the gas with vapor. The gas/vapor mixture is then delivered to the ALD chamber for deposition, again by opening and closing valves. The bubbler is widely used for CVD applications. Such bubblers are described in U.S. Patent Nos. 5,288,325and 6,579,372B2.

Both of these vapor generation and delivery methods involve placing the liquid in a heated vessel to generate vapor. The precursor liquid is in prolonged thermal contact with the vessel which is usually made of metal. For low vapor pressure liquids, the vessel temperature must be kept high. Prolonged contact between a liquid and a hot metal surface at a high temperature can lead to thermal decomposition of the precursor liquid and by-product formation resulting in degraded film quality and loss of product yield. In addition, the amount of vapor introduced per ALD cycle is usually quite small and can be difficult to control accurately. For these reasons, improved vaporization method and apparatus are needed for the ALD process for commercial production purposes.

Vapor generation in a controlled manner is possible by directly injecting a liquid into a heated vaporization chamber. Vapor generation in the milligram per second and higher rate is possible by this approach. When the rate of vapor generation and delivery falls below the milligram per second range, it becomes increasingly more difficult to control the amount of liquid injected reliably to make a direct liquid injection method of vaporization practical.

The present invention relates to an apparatus for vapor generation and delivery involving direct liquid injection, but at rates that are too low by conventional approaches being used. The approach described in this invention makes it possible to generate vapor reliably and with accuracy for delivery in the milligram per second range, as well as in the much lower ranges of microgram and nanogram per second. For ALD applications, the approach can be used to deliver precise doses of vapor of a few milligrams to a few micrograms that may be needed for ALD applications.

While the approach described in this invention is intended primarily for vapor delivery at very low delivery rates, the same approach can also be used at higher rates as a replacement for more common methods that are often unreliable and inaccurate.

### SUMMARY OF THE INVENTION

The present claims involve injecting a liquid and gas into a vapor holding chamber held at a sufficiently high temperature to insure all the liquid injected is vaporized and held in the chamber as a vapor. The gas/vapor mixture is then delivered to a second chamber maintained at a lower pressure for subsequent delivery to the deposition chamber in which the deposition substrate, i.e. the wafer, is held.

The two chambers described above are referred to respectively as the source chamber and the delivery chamber. Both chambers are preferably equipped with a pressure sensor to monitor the pressure of the gas/vapor mixture in the chamber. Both chambers are equipped with inlet and exit gas and liquid shut-off valves. When the pressure in the delivery chamber falls below a certain preset threshold due to vapor delivery to the deposition chamber, the valve between the source and delivery chambers is opened. This allows the gas/vapor mixture from the source chamber to flow into the delivery chamber, thereby restoring the delivery chamber to its proper operating pressure conditions. As the gas/vapor mixture flows into the delivery chamber, the source chamber pressure drops. When the pressure falls below a certain pre-set threshold, the required amount of gas and liquid is injected into the source chamber to restore the chamber pressure to the pre-set value. By this means, both the source and delivery chambers are controlled to within certain pressure limits, thereby insuring the constant vapor delivery at a precise rate. The method of approach can lead to extremely low vapor delivery rates in the milligram, microgram and nanogram per second ranges that are not possible by other vapor delivery methods.

The present invention includes an apparatus according to claim 1.

For ALD applications, a delivery chamber is usually sized to have a specific volume so that the required amount of gas and vapor mixture is held in the delivery chamber prior to gas/vapor delivery. The entire content of the delivery chamber is then delivered to the deposition chamber by opening the valve between the delivery and deposition chambers to deliver a precise dose of vapor along with a fixed amount carrier gas into the deposition chamber.

### BRIEF DESCRIPTION OF THE DRAWINGS

Figure 1 is a schematic view of the present invention.
Figure 2 is a schematic view of the gas and liquid injection system for the vapor generator of the present invention.

### DETAILED DESCRIPTION OF THE INVENTION

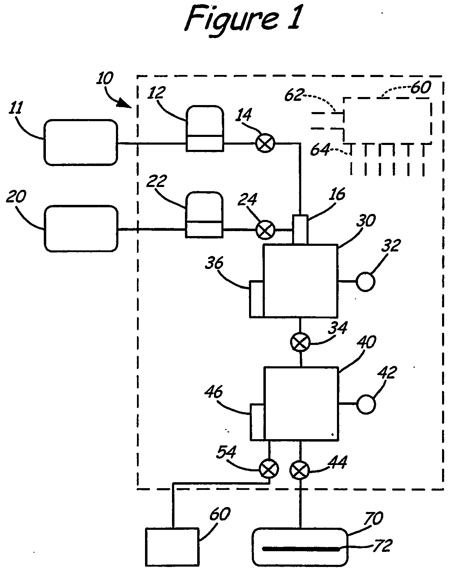

Figure 1 shows the preferred embodiment of the vaporizing apparatus. The vapor generation and delivery apparatus is shown generally at 10. A reservoir 20 which may be external to the system or be part of the system, contains a liquid under pressure. It provides a source of liquid (deposition component) for use in vaporization. A gas source 11 is also provided and may be external to the system. The reservoir 20 is connected to a liquid flow controller (LFC) 22 which is in turn connected to an inlet flow passageway 16 on the vaporization chamber 30 through the valve 24. The inlet flow passageway 16 provides a passageway for the liquid and gas to flow into the vaporization chamber, 30 from their respective liquid and gas sources. The gas source 11 is connected to a gas flow controller (GFC) 12 and valve 14 to a gas inlet on the inlet flow passageway 16 on the vaporization chamber 30.

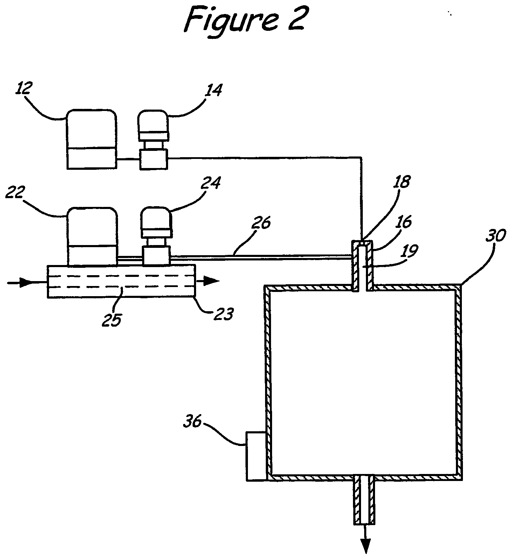

Figure 2 shows the manner in which gas and liquid are injected into the vaporization chamber 30 for vapor holding in more detail. The inlet flow passageway shown generally at 16 has a narrow passageway 19 to allow the injected liquid and gas to flow into the chamber 30 quickly. A small diameter orifice 18 is located at the inlet to allow the gas to flow at high velocity, usually at a sonic speed through an orifice (not shown), at the same time liquid is being injected into the passageway 19 just downstream of the orifice. The liquid injection is by means of a small diameter capillary tubing 26 connecting valve 24 to the inlet passageway. The high velocity gas flowing through the orifice insures that the injected liquid is atomized to form droplets, thereby enhancing the quick evaporation of the liquid in the vaporization chamber 30 to avoid droplet impaction on the hot metal chamber walls to avoid thermal decomposition, by-product formation, and contaminant generation that should be avoided.

By using small diameter tubing as the connecting passage for liquid flow from valve 24 to the passageway 19, the amount of liquid remaining in the connecting tube following the closure of the valve 24 can be kept very small. Since the exit end of the capillary tubing 26 is in close thermal contact with the vaporization chamber 30, it is at substantially the same temperature as chamber 30. For a typical vaporization temperature of, for example 100 °C, sufficient to cause liquid vaporization in chamber 30 for some liquids, the liquid in the capillary tubing in contact with the vaporization chamber will also vaporize. This vaporized liquid volume in the capillary will need to be filled when valve 24 is opened before the liquid can reach chamber 30 for delivery into the chamber for vaporization. The residual capillary tubing volume downstream of the shut-off valve 24 is referred to as a dead volume, and must be kept small when a small quantity of liquid is to be injected reliably into the chamber 30 for vaporization. The dead volume can be kept small by using small diameter capillary tubing as the connecting liquid flow passageway. The capillary is typically smaller than about 1.0 millimeter in diameter, but smaller capillaries with diameters as small as about 0.1 mm may need to be used for precise liquid delivery in some applications.

The liquid flow controller 22 and valve 24 are shown mounted on a metal cooling block 23 provided with fluid passageways 25 to allow a gas or liquid coolant to flow through and keep the flow controller 22 and the valve 24 at a low temperature. It is desirable to maintain both the flow controller and valve 24 at a cool temperature to avoid liquid vaporization in these components. Other mechanisms of cooling the liquid flow controller and liquid shut-off valve can also be used. Examples include the use of a cooling fin attached to the conductive metal base 23 to cause cooling by free convection. Cooling can also be provided with a thermoelectric cooling module to allow heat to be actively extracted by the thermoelectric cooling effect. Other mechanisms of cooling that are familiar to those skilled in the art of cooling system design can also be used and will not be described.

By using a small diameter capillary tube between the cooled liquid shut-off valve 24 and the heated vaporization chamber 30 the heat conduction from the chamber to the valve along the capillary tubing can be reduced and a substantially length of the capillary tubing 26 can be kept filled with the liquid that is at a sufficiently low temperature and thus not vaporized. This further contributes to the reduction of the actively dead volume that must be filled following the start of liquid flow in the capillary 26 and before the liquid reaches chamber 30 where it can be vaporized.

The amount of liquid injected into the vaporization chamber 30 via the inlet flow passageway 16 can be controlled by controlling the rate of liquid flow into the passageway 16. An electronic controller, shown generally at 60 in Figure 1 includes several output signals, 64. One such signal is applied to the liquid flow controller, 22, to control the rate of liquid flow to the desired set-point value. A second signal can be used to control the duration of valve opening for valve 24, so that the desired amount of liquid can be injected into the vaporization chamber 30.

The inlet flow passageway 16 also has a gas inlet allowing the pressurized gas 11, to flow through the gas flow controller (GFC) 12, then through valve 14 into the vaporization chamber 30. The same electronic controller 60 can be used to provide a control signal to set the GFC 12 to set the gas flow rate to the desired value. Another signal can be used to control the valve 14 and keep it open for the desired duration to inject a specific amount of gas into the vaporization chamber. A variety of carrier gases can be used depending on the application. The typical carrier gas for semiconductor thin film deposition includes argon, helium, hydrogen, and nitrogen, among others.

The vaporization chamber 30 as discussed previously is also referred to as a vapor holding chamber. The gas/vapor mixture in this chamber can be delivered directly to the deposition chamber for thin film deposition or a wafer. Alternatively, the mixture in the chamber can be delivered to a second chamber and then to the deposition chamber for thin film deposition. In the later case, the vaporization chamber 30 can be referred to as a source chamber, because the chamber 30 contains a source of vapor for subsequent delivery to a delivery chamber 40 and then the deposition chamber 70. Upon entering the chamber 30, the liquid encounters a high temperature environment in which the liquid will vaporize quickly to form a vapor. By design, the temperature of the source chamber 30 is kept at a sufficiently high value to insure that all the injected liquid will vaporize and form a vapor. The chamber 30 is thus kept dry, with all the injected liquid having been vaporized in the chamber, with no residual precursor in liquid form being left or present in the chamber. Unlike the conventional prior art bubbler, where a carrier gas is bubbled through the liquid in a chamber to saturate the gas with vapor for delivery to the deposition chamber, the source chamber 30 in the present invention is designed to run dry with the chamber containing only gas/vapor mixture following the initial injection of liquid into the chamber that is vaporized quickly.

The source chamber 30 is provided with a heater and temperature sensor 36. Upon receiving the temperature sensor output through one of its inlet signal lines, 62, the electronic controller 60 will generate an output signal to control the electrical power applied to heater, thus controlling the source chamber 30 to the desired operation temperature. The temperature of the source chamber 30 must be selected properly to insure all the injected liquid is vaporized. Usually, the larger the amount of injected liquid, the higher the temperature of chamber must be. Indeed, the chamber must be kept at a temperature higher than the saturation temperature of the liquid corresponding to the pressure of the vapor generated in the chamber. For instance, if the saturation vapor pressure of a liquid is 1 Torr at 50°C, then to inject liquid sufficient to generate vapor at a pressure of 1 Torr in the source chamber 30, the chamber must be kept at a minimum temperature of 50°C. Lower temperature will cause the incomplete vaporization of the liquid. Only a chamber temperature of 50°C or higher will insure the complete vaporization of the liquid.

The source chamber is usually made of metal such as stainless steel. To prevent the injected liquid from coming into direct contact with the hot metal surface, a carrier gas can be introduced into the chamber first to allow the gas to be heated to substantially the same temperature as the chamber. The liquid is then injected into the chamber. The injected liquid would thus come into contact with the hot gas first. Through design, the injected liquid can be vaporized completely prior to any residual liquid coming into contact with the hot chamber walls. To facilitate liquid vaporization, the inlet passageway 16 can be designed in the form of a compressed gas atomizer to form small liquid droplets, which would then vaporize quickly upon mixing with the hot gas inside the chamber. By this means, direct liquid to hot metal contact can be avoided thus eliminating the possibility of thermal decomposition of the precursor liquid chemical and by-product formation that are undesirable in semiconductor thin film deposition.

The source chamber 30 is provided with a valve 34 at the outlet end and a pressure sensor 32 to sense the pressure of the gas/vapor mixture in the chamber. To prevent vapor condensation in the pressure sensor 32, the sensor itself must be kept at a sufficiently high temperature. Similarly, valves 34 must also be kept at a sufficiently high temperature to prevent vapor condensation in the valve. Usually, the pressure sensor and the valves are kept at the same temperature as the source chamber, or a few degrees higher.

Connected to the source chamber 30 and downstream is the delivery chamber 40 which serves as a separate vapor holding chamber. The chamber 30 and the chamber 40 are separated by a valve 34. Like the source chamber 30, the delivery chamber 40 is also equipped with a pressure sensor 42, an electric heater and temperature sensor 46, and an exit valve 44 for vapor delivery to the deposition chamber 70.

Both chambers 30 and 40 need a source of vacuum to purge the chambers 30 and 40 and provide the chambers 30 and 40 with the respective vacuum needed for operation. Pump 50 is provided for this purpose. Pump 50 is connected to a second valve 54 located at a second exit on the chamber 40. The valve 54 can be opened to allow the chambers 30 and 40 to be pumped down to a vacuum and be purged of contaminants with a carrier gas prior to vapor generation and delivery.

To purge the system, the electronic controller 60 is set to control the source and delivery chambers 30 and 40 at a suitably high temperature. The temperature of the chambers 30 and 40 during purging is usually higher than the steady state operating temperature of the chambers to allow the chambers to be thoroughly purged of unwanted contaminants. A carrier gas is then introduced into the source chamber by opening the valve 14. The carrier gas then flows through the source and delivery chambers by opening valve 34 at the source chamber exit and through valve 54 at the delivery chamber exit to the vacuum pump 50. By allowing the gas to flow through the chambers for a suitable length of time, the system can be thoroughly purged of unwanted contaminants. Following purging, the valves are closed. The system is then ready to receive liquid and gas injection for vapor generation and gas/vapor delivery.

Beginning with both the source chamber 30 and the delivery chamber 40 at a relatively high vacuum, i.e. a low pressure, of a few Torr for most applications, and with valves 34, 44 and 54 closed, valve 14 is first opened to allow gas to flow into source chamber 30 until the gas pressure in the chamber reaches a selected value. Allowing for some time for the gas to be heated in the chamber to substantially the same temperature as the chamber walls, liquid valve 24 is opened allowing the precursor liquid to flow into the source chamber at a certain rate, along with any additional gas that may also flow through the gas flow controller 12. Allowing for sufficient time for the required amount of liquid to be injected into the chamber 30, valve 24 is closed. Valve 14 will remain open until the source chamber 30 pressure has built up to a certain preset value. Valve 14 is then closed. A typical source chamber pressure is 133322 Pa (1000 Torr). Higher pressure in the source chamber can be used if the deposition chamber 70 is designed to operate at a high pressure to insure that a sufficient pressure difference exists between the source and deposition chambers to enable the active and reliable control of vapor delivery.

A typical source chamber volume is 1.0 liter. To create a vapor pressure of a few Torr in the chamber, a few milligrams of liquid usually must be injected into the chamber. To pressurize the chamber to a pressure of, say, 133322 Pa (1000 Torr.) a sufficient amount of gas must then be injected into the chamber to achieve this pressure. At a chamber pressure of about 133322 Pa (1000 Torr) and a vapor pressure of 1 Torr, the gas/vapor mixture in the chamber will have a mixture to vapor molar ratio of about 1000 to 1. The molar concentration of the vapor in the chamber is thus about 0.001 mole of the mixture. By this means, a small molar fraction of the vapor can be generated reliably in a dry chamber by using accurate gas and liquid flow controllers and pressure sensors. The electronic controller is then used to carry out the sequence of steps needed for vapor and gas injection as well as gas/vapor mixture delivery to the deposition chamber.

To provide a constant rate of mixture delivery from the delivery chamber 40 to the deposition chamber, the delivery chamber pressure must be controlled to within narrow limits. For a typical source chamber of about 133322 Pa (1000 Torr), the nominal delivery chamber pressure is about 13332 Pa (100 Torr). This will insure accurate vapor delivery to a deposition chamber in the range of about 6666 Pa (50 Torr) or below making use of appropriate flow restrictions operating under critical flow conditions to provide a constant rate of mixture flow.

As the gas/vapor mixture flows out of the delivery chamber 40, the chamber pressure drops. Upon reaching a preset value, for example about 12665 Pa (95 Torr), the valve 34 will open allowing the gas/vapor mixture to flow out of the source chamber into the delivery chamber. As the gas/vapor is delivered into the delivery chamber, the chamber pressure will rise. Upon reach the set-point value of about 13332 Pa (100 Torr), valve 34 will close automatically stopping the gas flow into the chamber. By this means, the delivery chamber can be kept between narrow pressure limits to insure constant rate of mixture flow during the time of delivery from the delivery chamber to the deposition chamber.

As gas/vapor is delivered from the source chamber 30 to the delivery chamber 40, the source chamber pressure will drop. However, as long as the source chamber pressure is at a higher elevation than the delivery chamber pressure, the source chamber is capable of providing a source of gas/vapor mixture to keep the delivery chamber at its set-point pressure. For instance, for an initial chamber pressure of about 133322 Pa (1000 Torr) and a nominal set-point pressure of about 13332 Pa (100 Torr) in the delivery chamber, the source chamber is capable of providing a continual supply of gas/vapor mixture to the delivery chamber until the source chamber drops below the desired delivery chamber pressure of about 13332 Pa (100 Torr).

Upon sensing the source chamber pressure having dropped to a sufficient low level, for example about 26664 Pa (200 Torr), valves 14 and 24 can be opened to allow gas and liquid to be injected into the source chamber at their respective desired rate of flow. Following the injection of the required amount of liquid into the source chamber 30, liquid valve 24 is closed, while gas valve 14 will remain open until the source chamber has built up to the desired source chamber pressure. Upon reaching the desired source chamber pressure, valve 14 is closed. By this means, the source chamber can be replenished with the desired amount of gas and liquid to maintain a proper gas/vapor mixture ratio in the source chamber. Since the source chamber is designed to be supplied with a gas/vapor mixture of a constant composition, the same composition of gas/vapor mixture is delivered to the delivery chamber. By this means both the source and delivery chambers will operate at the same mixture ratio depending on the relative amounts of gas and liquid injected into the source chamber. By using a sufficiently large source chamber volume, the injected mass of liquid and gas can also be kept high and within the capabilities of the conventional liquid and gas flow controllers.

Designing a vapor generation and delivery system for accurate vapor generation and delivery at low rates of flow as described above can be implemented with different variations involving different chamber sizes, pressure, pressure and temperature control schemes, as well as operational steps that may differ from one application to another. All of these can be done without substantially departing from the approach described above in this invention. There are variations in the actual design and operational steps will be obvious to those skilled in the art of vapor generation and vapor/gas delivery. These variations will not be further described.

## Claims

1. An apparatus (10) for vaporizing a deposition component for thin film deposition on a substrate, the apparatus including a chamber (30), a mechanism for injecting the deposition component into the chamber (30), wherein the mechanism for injecting the deposition component into the chamber (30) comprises a passageway (16) through which the deposition component enters the chamber (30), and a gas inlet through which gas enters the passageway (16) and a deposition component inlet through which the deposition component enters the passageway (16), the deposition component inlet being positioned downstream of the gas inlet; a liquid source of the deposition component (20) and a capillary tube (26) connecting the liquid source (20) to the passage (16), wherein the capillary (26) is smaller than 1.0 millimeter in diameter; and wherein the passageway (16) and the capillary (26) are in heat conductive contact such that the deposition component is vaporized in the passageway (16) and in a downstream portion of the capillary; said chamber (30) being held at a sufficiently high temperature to vaporize substantially all the deposition component injected, and a mechanism to hold the vapor in said chamber (30) for subsequent delivery and film formation.

2. The apparatus of claim 1 wherein the gas inlet includes an orifice (18) through which the gas flows at sonic speed.

3. The apparatus according to any preceding claims, further comprising a liquid flow controller (22) and a valve (24), wherein the liquid source (20) is connected to the liquid flow controller (22), which is in turn connected to the passageway (16) through the valve (24).

4. The apparatus, according to any preceding claims, further comprising a gas source (11), a gas flow controller (12), and a valve (14); wherein the gas source (11) is connected to the gas flow controller (12) and the valve (14) to the gas inlet on the passageway (16).

5. The apparatus, according to any preceding claims, wherein the deposition component source (20) is cooled sufficiently such that vaporization of the deposition component occurs in the downstream portion of the capillary.

6. The apparatus, according to any preceding claims, further comprising a metal cooling block (23); wherein the liquid flow controller (22) and the valve (24) are mounted on the metal cooling block (23) for being kept at low temperature.

7. The apparatus, according to any preceding claims, wherein the chamber (30) is provided with a heater and a temperature sensor (36).

8. The apparatus, according to any preceding claims, wherein the chamber (30) is provided with a valve (34) at the outlet end and a pressure sensor (32) to sense the pressure of the gas/vapor mixture in the chamber.

9. The apparatus, according to any preceding claims, wherein the chamber (30) is made of metal, preferably made of stainless steel.

10. The apparatus according to claim 9, wherein the passageway (16) is in the form of a compressed gas atomizer for forming liquid droplets of the deposition component which vaporize in the source chamber (30).

11. The apparatus, according to any preceding claims, further comprising a delivery chamber (40), wherein the delivery chamber (40) is connected downstream to the chamber (30) through the valve (34).

12. The apparatus, according to any preceding claims, further comprising a deposition chamber (70).

13. The apparatus, according to the claim 12, wherein the delivery chamber (40) is provided with a pressure sensor (42), and electric heater and temperature sensor (46), and an exit valve (44) for vapor delivery to the deposition chamber (70).

14. The apparatus, according to any claims 11 to 13, further comprising a pump (50) and a valve (54), wherein the pump (50) is connected to the valve (54) located at a second exit on the chamber (40).

## Patentansprüche

1. Vorrichtung (10) zum Verdampfen einer Abscheidungskomponente für Dünnfilmabscheidung auf einem Substrat, wobei die Vorrichtung eine Kammer (30) und einen Mechanismus zum Zuführen der Abscheidungskomponente in die Kammer (30) aufweist, wobei der Mechanismus zum Zuführen der Abscheidungskomponente in die Kammer (30) einen Durchgang (16), durch den die Abscheidungskomponente in die Kammer (30) eintritt, einen Gaseinlass, durch den Gas in den Durchgang (16) eintritt, und ein Abscheidungskomponenteneinlass, durch welchen die Abscheidungskomponente in den Durchgang (16) eintritt, umfasst, wobei der Abscheidungskomponenteneinlass stromabwärts dem Gaseinlass liegt; und die Vorrichtung eine Flüssigkeitsquelle der Abscheidungskomponente (20) und eine Kapillarröhre (26), die die Flüssigkeitsquelle (20) mit dem Durchgang (16) verbindet, umfasst, wobei die Kapillare (26) einen kleineren Durchmesser als 1 mm aufweist; und wobei der Durchgang (16) und die Kapillare (26) in wärmeleitendem Kontakt stehen, sodass die Abscheidungskomponente im Durchgang (16) einem stromabwärtsliegenden Teil der Kapillare verdampft wird, wobei die Kammer (30) auf eine ausreichend hohe Temperatur gehalten wird, um im Wesentlichen die gesamte zugeführte Abscheidungskomponente zu verdampfen und die Vorrichtung einen Mechanismus umfasst, um den Dampf zum folgenden Anliefern und Filmbilden in der Kammer (30) zu halten.

2. Vorrichtung nach Anspruch 1, wobei der Gaseinlass eine Düse (18), durch die das Gas mit Schallgeschwindigkeit fließt, umfasst.

3. Vorrichtung nach einem der vorhergehenden Ansprüche, ferner umfassend einen Flüssigkeitsflussregler (22) und ein Ventil (24), wobei die Flüssigkeitsquelle (20) mit dem Flüssigkeitsflussregler (22) verbunden ist, der wiederum mit dem Durchgang (16) durch das Ventil (24) verbunden ist.

4. Vorrichtung nach einem der vorhergehenden Ansprüche, ferner umfassend eine Gasquelle (11), einen Gasflussregler (12) und ein Ventil (14), wobei die Gasquelle (11) mit dem Gasflussregler (12) und dem Ventil (14) an den Gaseinlass des Durchgangs (16) verbunden ist.

5. Vorrichtung nach einem der vorhergehenden Ansprüche, wobei die Abscheidungskomponentenquelle (20) ausreichend gekühlt ist, sodass das Verdampfen der Abscheidungskomponente im stromabwärtsliegenden Teil der Kapillare erfolgt.

6. Vorrichtung nach einem der vorhergehenden Ansprüche, ferner umfassend einen Metallkühlblock (23), wobei der Flüssigkeitsflussregler (22) und das Ventil (24) auf dem Metallkühlblock (23) montiert sind, um auf einer geringen Temperatur gehalten zu werden.

7. Vorrichtung nach einem der vorhergehenden Ansprüche, wobei die Kammer (30) mit einem Heizgerät und einem Temperatursensor (36) bereitgestellt ist.

8. Vorrichtung nach einem der vorhergehenden Ansprüche, wobei die Kammer (30) mit einem Ventil (34) am Auslassende und einem Drucksensor (32) bereitgestellt ist, um den Druck des Gases/Dampfmischung in der Kammer zu messen.

9. Vorrichtung nach einem der vorhergehenden Ansprüche, wobei die Kammer (30) aus Metall, vorzugsweise aus rostfreiem Stahl, ist.

10. Vorrichtung nach Anspruch 9, wobei der Durchgang (16) in Form eines komprimierten Gaszerstäubers zum Formen flüssiger Tropfen der Abscheidungskomponente, das in der Quellkammer (30) zerstäubt wird, geformt ist.

11. Vorrichtung nach einem der vorhergehenden Ansprüche, ferner umfassend eine Auslieferkammer (40), wobei die Auslieferkammer (40) stromabwärts mit der Kammer (30) durch das Ventil (34) verbunden ist.

12. Vorrichtung nach einem der vorhergehenden Ansprüche, ferner umfassend eine Abscheidungskammer (70).

13. Vorrichtung nach Anspruch 12, wobei die Auslieferkammer (40) mit einem Drucksensor (42) und einem elektrischen Heizgerät, einem Temperatursensor (46) sowie einem Ausgangsventil (44) zur Dampflieferung an die Abscheidungskammer (70) bereitgestellt ist.

14. Vorrichtung nach einem der Ansprüche 11 bis 13, ferner umfassend eine Pumpe (50) und ein Ventil (54), wobei die Pumpe (50) mit dem Ventil (54) verbunden und an einem zweiten Ausgang der Kammer (40) angeordnet ist.

## Revendications

1. Appareil (10) permettant de vaporiser un composant de dépôt pour dépôt de couche mince sur un substrat, l'appareil incluant une chambre (30), un mécanisme pour injecter le composant de dépôt dans la chambre (30), dans lequel le mécanisme permettant d'injecter le composant de dépôt dans la chambre (30) comprend un passage (16) à travers lequel le composant de dépôt pénètre dans la chambre (30), et une entrée de gaz à travers laquelle du gaz pénètre dans le passage (16) et une entrée de composant de dépôt à travers laquelle le composant de dépôt pénètre dans le passage (16), l'entrée du composant de dépôt étant positionnée en aval de l'entrée de gaz ; une source de liquide du composant de dépôt (20) et un tube capillaire (26) reliant la source de liquide (20) au passage (16), dans lequel le capillaire (26) a un diamètre inférieur à 1,0 millimètre ; et dans lequel le passage (16) et le capillaire (26) sont en contact thermoconducteur de telle sorte que le composant de dépôt est vaporisé dans le passage (16) et dans une partie en aval du capillaire ; ladite chambre (30) étant maintenue à une température suffisamment élevée pour vaporiser sensiblement la totalité du composant de dépôt injecté, et un mécanisme pour maintenir la vapeur dans ladite chambre (30) pour distribution ultérieure et formation de couche.

2. Appareil selon la revendication 1, dans lequel l'entrée de gaz inclut un orifice (18) à travers lequel le gaz s'écoule à vitesse sonique.

3. Appareil selon l'une quelconque des revendications précédentes, comprenant en outre un régulateur de débit de liquide (22) et une valve (24), dans lequel la source de liquide (20) est reliée au régulateur de débit de liquide (22), qui est à son tour relié au passage (16) par le biais de la valve (24).

4. Appareil selon l'une quelconque des revendications précédentes, comprenant en outre une source de gaz (11), un régulateur de débit de gaz (12) et une valve (14) ; dans lequel la source de gaz (11) est reliée au régulateur de débit de gaz (12) et la valve (14) à l'entrée de gaz sur le passage (16).

5. Appareil selon l'une quelconque des revendications précédentes, dans lequel la source du composant de dépôt (20) est refroidie suffisamment de sorte à ce que la vaporisation du composant de dépôt se produise dans la partie en aval du capillaire.

6. Appareil selon l'une quelconque des revendications précédentes, comprenant en outre un bloc de refroidissement de métal (23) ; dans lequel le régulateur de débit de liquide (22) et la valve (24) sont montés sur le bloc de refroidissement de métal (23) pour être maintenus à basse température.

7. Appareil selon l'une quelconque des revendications précédentes, dans lequel la chambre (30) est dotée d'un élément chauffant et capteur de température (36).

8. Appareil selon l'une quelconque des revendications précédentes, dans lequel la chambre (30) est dotée d'une valve (34) au niveau de l'extrémité de sortie et d'un capteur de pression (32) pour détecter la pression du mélange gaz/vapeur dans la chambre.

9. Appareil selon l'une quelconque des revendications précédentes, dans lequel la chambre (30) est composée de métal, de préférence, composée d'acier inoxydable.

10. Appareil selon la revendication 9, dans lequel le passage (16) se présente sous la forme d'un atomiseur de gaz comprimé permettant de former des gouttelettes liquides du composant de dépôt qui se vaporisent dans la chambre (30).

11. Appareil selon l'une quelconque des revendications précédentes, comprenant en outre une chambre de distribution (40), dans lequel la chambre de distribution (40) est reliée en aval à la chambre (30) par le biais de la valve (34).

12. Appareil selon l'une quelconque des revendications précédentes, comprenant en outre une chambre de dépôt (70).

13. Appareil selon la revendication 12, dans lequel la chambre de distribution (40) est dotée d'un capteur de pression (42), et d'un élément chauffant électrique et capteur de température (46), et d'une valve de sortie (44) permettant la distribution de vapeur à la chambre de dépôt (70).

14. Appareil selon l'une quelconque des revendications 11 à 13, comprenant en outre une pompe (50) et une valve (54), dans lequel la pompe (50) est reliée à la valve (54) située au niveau d'une seconde sortie sur la chambre (40).
